# EUROPEAN PATENT APPLICATION

(11) **EP 4 156 279 A1**
(43) Date of publication of application: **29.03.2023**
(21) Application number: 21199107.0
(22) Date of filing: 27.09.2021
(51) Int. Cl.: H01L 29/06, H01L 29/40, H01L 29/78

(54) **SEMICONDUCTOR DIE AND METHOD OF MANUFACTURING THE SAME**

(71) Applicant: Infineon Technologies Austria AG, 9500 Villach (AT)
(72) Inventor: BLANK, Oliver, 9500 Villach (AT)
(74) Representative: König Szynka Tilmann von Renesse Patentanwälte Partnerschaft mbB München

(57) **Abstract**

The disclosure relates to a semiconductor die (1) with a semiconductor device (2) comprising a gate region (3) with a gate electrode (3.1) in a gate trench (23) for controlling a current flow through the device (2), and a field electrode region (4) with a field electrode (4.1) in a field electrode trench (24) which is needle-shaped, and with an edge termination structure (5) between the semiconductor device (2) and a lateral edge (6) of the die (1), comprising a shield electrode region (7) with a shield electrode (7.1) in a shield electrode trench (37), the shield electrode (7.1) electrically connected to the gate electrode (3.1).

## Description

### TECHNICAL FIELD

The present disclosure relates to a semiconductor die in which a semiconductor device is formed.

### BACKGROUND

The device comprises a gate electrode in a gate trench. Via a gate voltage applied to the gate electrode, a channel formation in a channel region can be controlled, e. g. to control a vertical current flow between source and drain. Moreover, the device comprises a field electrode in a field electrode trench, which can for instance increase the breakdown voltage.

### SUMMARY

It is an object of the present application to provide a semiconductor die with improved characteristics.

This object is achieved by the semiconductor die of claim 1, which comprises an edge termination structure between the device and a lateral edge of the die. In the edge termination structure, a shield electrode is arranged in a shield electrode trench, e. g. for shielding the device from an edge or backside potential of the die, for instance from the drain to source potential. The shield electrode is electrically connected to the gate electrode, namely configured to be on gate potential. As discussed in detail below, this can for instance simplify a wiring in a metallization layer and/or allow for a smaller spacing between the edge termination structure and an active area comprising the device, e. g. in comparison to a shield electrode connected to source.

Depending on the design, such a shield electrode connected to source would for instance require a plurality of fine structured conductor lines extending between the device and the edge termination structure. These conductor lines arranged side by side would be from line to line alternately on source potential, connecting the shield electrode to source, and on gate potential, connecting the gate electrode to the gate runner. In particular with decreasing cell sizes (pitch shrink), e. g. in case of lower voltage classes, the distance between these conductor lines would become very small (two conductor lines needed per cell pitch). This can be relevant in reliability testing, e. g. in a high humidity high temperature gate stress test, and/or increase the requirements for the passivation. Vice versa, the shield electrode connected to the gate electrode, as described in the present application, can enable a comparably easy implementation, in particular when the edge termination structure comprises a gate runner, namely is connected to the gate electrode of the device anyway.

Advantageous embodiments and features are provided throughout the disclosure and in particular in the dependent claims. The individual features shall be disclosed independently of a specific claim category, the disclosure relates to apparatus and device aspects, but also to method and use aspects. If for instance a die manufactured in a specific way is described, this is also a disclosure of a respective manufacturing process, and vice versa. In general words, an approach of this application is to configure a shield electrode arranged in an edge termination structure outside an active area of the die to be on gate potential. Depending on the device formed in the active area, the gate voltage can for instance be 0 V during a switching event, being the same like for instance a source voltage in a low side configuration.

The shield electrode trench can have an elongated extension, e. g. in parallel to a gate runner formed in the edge termination structure, see in detail below. Alternatively, the shield electrode can be needle-shaped, wherein a plurality of respectively needle-shaped shield electrode regions can be arranged in the edge termination structure, their respective shield electrodes electrically connected to the gate electrode. These geometries can also be combined, the edge termination structure comprising needle-shaped and elongated shield electrode trenches. Independently of their lateral extension, the trench or trenches is/are etched vertically into a semiconductor body of the die.

Laterally aside the edge termination structure, the active area with the device is arranged. The device comprises the gate and the field electrode region, its channel region can for instance be arranged laterally aside the gate region. The latter can comprise a gate dielectric in addition to the gate electrode, which capacitively couples the gate electrode to the channel region. By applying a voltage to the gate electrode, a channel path formation and current flow can be controlled. The gate electrode can be formed in a trench etched into the semiconductor body, wherein the gate and the field electrode region can be arranged in the same trench, the field electrode region below the gate region, or in separate trenches. In the latter case the gate trench can surround a respective device cell seen in a top view, the needle-shaped field electrode arranged for instance centrally in the cell in a needle trench.

The device can in particular be a field effect transistor comprising a source and a drain region. Referring to a source and a drain region of a first conductivity type, e. g. n-type, the channel region can be formed in a body region of a second conductivity type opposite to the first conductivity type, e. g. p-type. In particular, the source region can be formed at a frontside of the semiconductor body and the drain region at a backside thereof, the channel region and for instance a drift region arranged vertically between, e. g. the drift region between the channel region and the drain region. The drift region can be of the first conductivity type as well, wherein its dopant concentration is lower compared to the drain region. As a power device, such a transistor can for instance have a breakdown voltage of at least 10 V, 20 V, 30 V, 40 V or 50 V, possible upper limits being for example not more than 800 V, 600 V, 400 V, 200 V or 100 V.

In an embodiment, the gate dielectric of the device is thinner than a shield dielectric of the shield electrode region. The shield dielectric can isolate the shield electrode from a semiconductor body, into which the shield electrode trench is etched. In particular, the shield dielectric can for example have at least a 1.5-, 2- or 2.5-fold thickness of the gate dielectric, upper limits being for instance not more than a 100-, 50-, 20-, 10- or 5-fold thickness. The respective thickness can for instance be taken in the lateral direction, e. g. in case of a vertical device with the channel region laterally aside the gate region. In detail, the ratio between the shield dielectric and the gate dielectric thickness can for instance depend on the required voltage class (breakdown voltage) and threshold voltage.

In absolute values, the gate dielectric can for instance have a thickness of at least 14 nm and/or the field dielectric a thickness of at least 21 nm. Upper limits can for instance be 100 nm for the gate dielectric thickness and/or 1000 nm for the field dielectric thickness.

In an embodiment, the shield electrode trench extends deeper than the gate trench. Seen in a vertical cross-section, its lower end can be arranged deeper than a lower end of the gate trench. Generally, in this disclosure, "vertically" refers to the vertical direction, which lies for instance perpendicular to a surface of the die, e. g. a front or backside surface of the semiconductor body. "Deeper" or "below" means at a larger vertical distance from the frontside of the die or semiconductor body, wherein "above" or "higher" means at a smaller vertical distance from the frontside. From the frontside, for example the trench or trenches can extend into the semiconductor body. The shield electrode trench can for instance have at least a 1.5-, 2-or 2.5-fold depth compared to the gate trench (upper limits being for example a 25-, 20-, 15-, 10- or 5-fold depth), wherein the upper ends of these trenches can in particular lie on the same vertical height.

In an embodiment, a plurality of needle-shaped shield electrode trenches, each comprising a respective shield electrode, are formed in the edge termination structure. Along the active area, these shield electrode trenches/electrodes can be arranged in a row, which can for instance lie parallel to the gate runner (e. g. below the latter). Perpendicular thereto, e. g. in a lateral direction defining the lateral distance between the active area and the edge termination structure, one or at least two of these rows can be arranged consecutive, namely laterally aside and for instance in parallel to each other. Independently of these details, the needle-shaped shield electrodes can for instance be arranged in the same pattern as the needle-shaped field electrodes of the device, e. g. with the same pitch, at least with respect to one lateral direction, in particular with respect to two lateral directions perpendicular to each other.

In an embodiment, the shield electrode trench has a longitudinal extension in a lateral direction, e. g. in parallel to the lateral edge of the die. As mentioned, longitudinal and needle-shaped shield electrodes can be combined in the edge termination structure, or they can be alternatives. The longitudinal shield electrode trench can for instance be arranged below and/or extend in parallel to a gate runner of the edge termination structure. Generally, the longitudinal shield electrode trench can be combined with needle-shaped field electrodes of the device, a different trench geometry applied in the active area and in the edge termination structure. Alternatively, the longitudinal shield electrode trench can also be combined with a longitudinal field electrode of the device, formed in a longitudinal trench in the active area. This shall also be disclosed as an alternative to claim 1

Generally, it shall be disclosed a semiconductor die with a semiconductor device comprising a gate region with a gate electrode in a gate trench for controlling a current flow through the device, and a field electrode region with a field electrode in a field electrode trench, an edge termination structure between the semiconductor device and a lateral edge of the die, comprising a shield electrode region with a shield electrode in a shield electrode trench, the shield electrode electrically connected to the gate electrode. In particular, the field electrode can have a longitudinal extension and be arranged in a longitudinal field electrode trench. The device can particularly comprise a plurality of longitudinal field electrodes/trenches, e. g. arranged as parallel stripes. This longitudinal field electrode/trench design can, as mentioned, in particular be combined with the longitudinal shield electrode/trench, which can for instance extend perpendicularly to the field electrode stripes formed in the active area.

In general words, the shield electrode can be connected to the gate electrode of the device via a connecting element extending between the active area and the edge termination structure, e. g. via a conductor line formed in a metallization layer above. In a particular embodiment, a connecting gate trench comprising a connecting gate electrode extends from the gate trench of the device to the edge termination structure. The connecting gate electrode connects the gate and shield electrodes with each other, wherein the arrangement in the trench can for instance allow for a space-saving layout. The connecting gate trench can in particular have the same depth like the gate trench of the device.

In a particular embodiment, the connecting gate trench extends into the shield electrode region, it can in particular extend laterally through the shield dielectric. The connecting gate electrode and the shield electrode can be formed in a direct contact with each other, this contact as such providing the electrical connection. In particular, however, a vertical interconnect can extend into the shield electrode region and the connecting gate trench, contacting the gate and shield electrodes. On the semiconductor body, an insulating layer can be arranged, wherein the vertical interconnect extends through this insulating layer down into the semiconductor body, namely into the shield electrode trench. The vertical interconnect is laterally aligned with the shield electrode, in terms of the lateral position arranged at least with a lateral overlap.

In an embodiment, a first metallization structure covers the shield electrode region at least partly and connects the shield and gate electrodes. This metallization structure can in particular be formed in a "first metallization layer" (see below for further details), which can for instance be a tungsten layer. Above, a frontside metallization can be formed ("second metallization layer", see below), e. g. a Cu or in particular Al layer, e. g. AlCu. In a particular embodiment, the connecting gate trench reaches below the first metallization structure. Basically, this can also apply for the vertical interconnect laterally aligned with the shield electrode, the first metallization structure connecting for instance the connecting gate electrode/shield electrode (connected by the vertical interconnect) to another or other shield electrode(s), e. g. laterally outside in the edge termination structure.

Alternatively, the connecting gate electrode can be connected to the first metallization structure via a vertical interconnect arranged laterally aside the shield electrode region. In this case, an additional vertical interconnect can form the connection between the metallization structure and the shield electrode. In case of the needle-shaped shield electrodes/trenches, the vertical interconnect of the connecting gate electrode can be integrated into a pattern formed by these trenches, e. g. arranged basically centrally in between.

The first metallization structure can in particular be a gate runner extending along at least one side of the active area, in particular along at least one side of the die. The gate runner can contact to gate contacts/regions of different cells of the device. The cells can be arranged in the active area aside each other, e. g. as stripes or in particular as polygonal (e. g. rectangular/quadratic cells), the gate runner biasing the cells to the same gate potential. Geometrically, the gate runner can extend only along one side or in particular along at least two sides of the active area/the die. Seen in a vertical top view, it can have an L- or U-or O-shape (extending along two, three or four sides).

In an embodiment, the first metallization structure is formed in a first metallization layer, and a second metallization layer is formed above. The second metallization layer can for instance be thicker than the first layer, it can in particular be the uppermost metallization layer of the die. In the first and/or second metallization layer, a respective metallization plate can be formed above the device, which can in particular be a respective source plate connected to the source region of the device and configured to be on source potential. Vice versa, the first metallization structure, and a possible second metallization structure formed above in the second metallization layer can be on gate potential, wherein this connection can particularly be made via the connecting gate trench (see above), e. g. without any wiring between the active area and the edge termination structure in the metallization layer or layers.

In a particular embodiment, a lateral distance between the first metallization plate formed above the device and the first metallization structure is 20 µm at maximum, further upper limits being 15 µm, 12 µm, 10 µm, 8 µm, 6 µm or 4 µm. Lower limits can for instance depend on design rules and layer thicknesses, e. g. be 100 nm, 200 nm or 300 nm at minimum. By assigning the shield electrode(s) to gate potential, and in particular with the integration into the gate runner structure, the wiring can be simplified and the active area and the edge termination structure can be arranged closer to each other. Alternatively or in addition, a first lateral distance taken between the first metallization structure and the first metallization plate can be smaller than a second lateral distance taken between the second metallization plate and the second metallization structure. Independently of this ratio, the second lateral distance can for instance be 30 µm, 25 µm, 20 µm or 15 µm at maximum, possible lower limits being for example 2 µm, 4 µm or 5 µm.

The application relates also to a method of manufacturing a semiconductor die, comprising the steps
- etching a gate trench and forming a gate region;
- etching a field electrode trench and forming a field electrode, in particular a needle-shaped field electrode trench and a field electrode region with a needle-shaped field electrode;
- etching a shield electrode trench and forming a shield electrode region.

Regarding further possible details, reference is also made to the description above.

In a particular embodiment, the field electrode trench in the active area and the shield electrode trench in the edge termination structure are etched simultaneously, in the same etch step. In particular, a plurality of needle-shaped field electrode trenches can be etched in the active area, while at the same time a plurality of needle-shaped shield electrode trenches are etched in the edge termination structure. Subsequently, the field and shield electrode region can for instance be formed simultaneously.

In a particular embodiment, the gate trench in the active area and the connecting gate trench, in which the connecting gate electrode is formed subsequently, are etched simultaneously (in the same etch step). This can allow for a process integration, the connection to the shield electrode can be formed without or with a reduced number of additional process steps. In particular, the gate electrode of the device and the connecting gate electrode can be formed simultaneously. Alternatively or in addition, a gate dielectric of the device and a dielectric containing the connecting gate electrode in the connecting gate electrode trench can be formed simultaneously.

### BRIEF DESCRIPTION OF THE DRAWINGS

Below, the semiconductor die and the method of manufacturing the same are explained in further detail by means of exemplary embodiments. The individual features can also be relevant for the disclosure in a different combination.
- Figure 1: shows a schematic top view of a die comprising a device in an active area and an edge termination structure aside;
- Figure 2: illustrates the device of figure 1 in a vertical cross section;
- Figure 3: shows a shield electrode formed in the edge termination structure of the die of figure 1 in a vertical cross-section;
- Figure 4: shows the shield electrode of figure 3 in a top view and illustrates a connecting gate electrode;
- Figure 5: shows a die in a top view, comprising a device like the die of figure 1, but differing in a connection of its edge termination structure;
- Figure 6: illustrates another die in a vertical top view, which comprises an elongated shield electrode trench in an edge termination structure;
- Figure 7: summarizes some process steps in a flow diagram.

### DETAILED DESCRIPTION

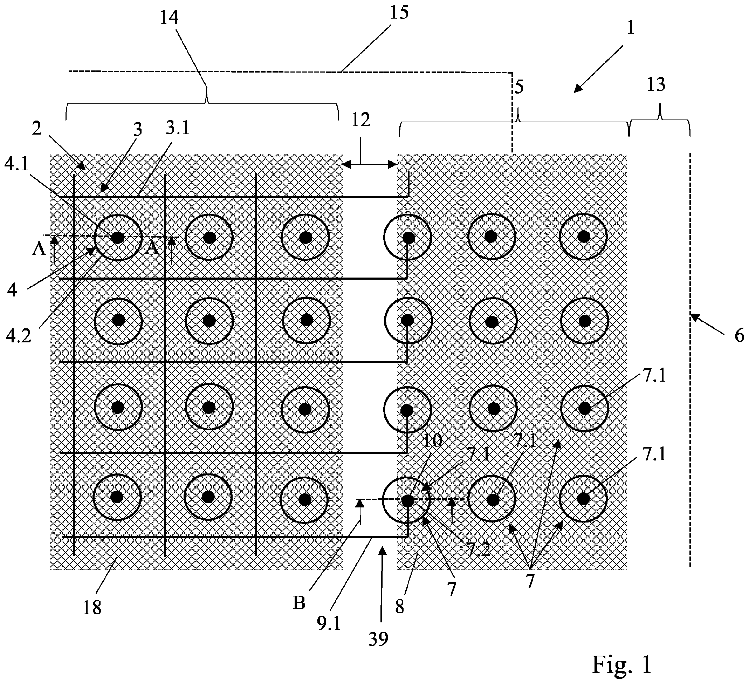

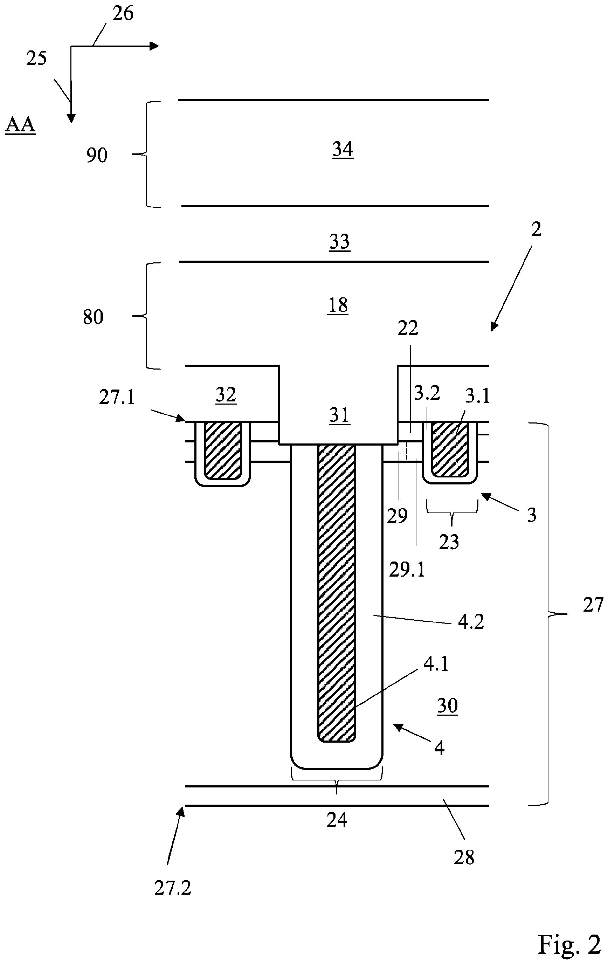

Figure 1 shows a portion of a die 1, wherein a device 2 with a gate region 3 and a field electrode region 4 is formed in an active area 14 of the die 1. As explained with reference to figure 2 in detail below, the device 2 is a field effect transistor, wherein a plurality of transistor cells are formed in the active area 14 and connected in parallel. Via the gate region 3 comprising a gate electrode 3.1, a vertical current flow through the device 2 can be controlled. In the example shown, the frontside of the die 1 is on source potential and its backside on drain potential. In an edge region 13 at a lateral edge 6, this backside potential can reach up to the frontside of the die 1. To shield the device 2, an edge termination structure 5 with a shield electrode region 7 is formed laterally between the lateral edge 6 and the active area 14.

The shield electrode region 7 comprises a shield electrode 7.1 and a shield dielectric 7.2 which isolates the shield electrode from the semiconductor body. The shield electrode 7.1 is electrically connected to the gate electrode 3.1, namely is on gate potential. E. g. during a switching event, the gate potential can be 0 V, for example like the source potential in a low side configuration, and the respectively biased shield electrodes 7.1 can shield the active area 14 for instance from a positive backside/drain potential.

A plurality of shield electrodes 7.1 are formed in the edge termination structure 5, each having a needle-shape. The field electrodes 4.1 formed in the active area 14 respectively have a needle-shape, like the shield electrodes 7.1, wherein the field and shield electrodes 4.1, 7.1 are arranged in the same pattern, e. g. based on the same cell type (quadratic in this example) and with the same pitch. The shield electrodes 7.1 are covered and connected to each other by a first metallization structure 8 formed in a first metallization layer, and the field electrodes 4.1 are covered and connected to each other by a first metallization plate 18. The electrical connection between the shield electrodes 7.1 and the gate electrode 3.1 is made via a connecting gate electrode 9.1 formed in a connecting gate trench 39, so that for instance no additional wiring between the active area 14 and the edge termination structure 5 is required in the first metallization layer. Consequently, a lateral distance 12 between the first metallization structure 8 and the first metallization plate 18 can become rather small, allowing for a space saving layout.

Figure 2 illustrates the device 2 of figure 1 in a vertical cross-section. The sectional plane AA (see also figure 1) lies parallel to a vertical direction 25 and a lateral direction 26. The gate region 3 with the gate electrode 3.1 and the gate dielectric 3.2 is formed in a gate trench 23 etched into a semiconductor body 27. At a frontside 27.1 of the semiconductor body 27, a source region 22 is formed, and a drain region 28 is arranged at its backside 27.2. Below the source region 22, a body region 29 with a channel region 29.1 is arranged, and between the body region 29 and the drain region 28 a drift region 30 is formed. In the example shown, the source region 22, drift region 30 and drain region 28 are n-doped, and the body region 29 is p-doped.

Laterally aside the gate trench 23, a field electrode trench 24 is etched into the semiconductor body 27, it extends deeper into the drift region 30. In this needle-shaped field electrode trench 24, the field electrode region 4 with the field electrode 4.1 and a field dielectric 4.2 is formed. The needle-shaped shield electrode 4.1 is on source potential, connected via a contact plug 31, which additionally contacts the source region 22 and the body region 29. The contact plug 31, made for example of tungsten, extends through an insulating layer 32 formed on the frontside 27.1 of the semiconductor body 27. Above, the first metallization plate 18 is arranged, formed in a first metallization layer 80. Above, a further insulating layer 33 and a second metallization plate 34 are arranged, the latter formed in a second metallization layer 90. The first and second metallization plates 18, 34 are connected to each other via interconnects, which are not shown here.

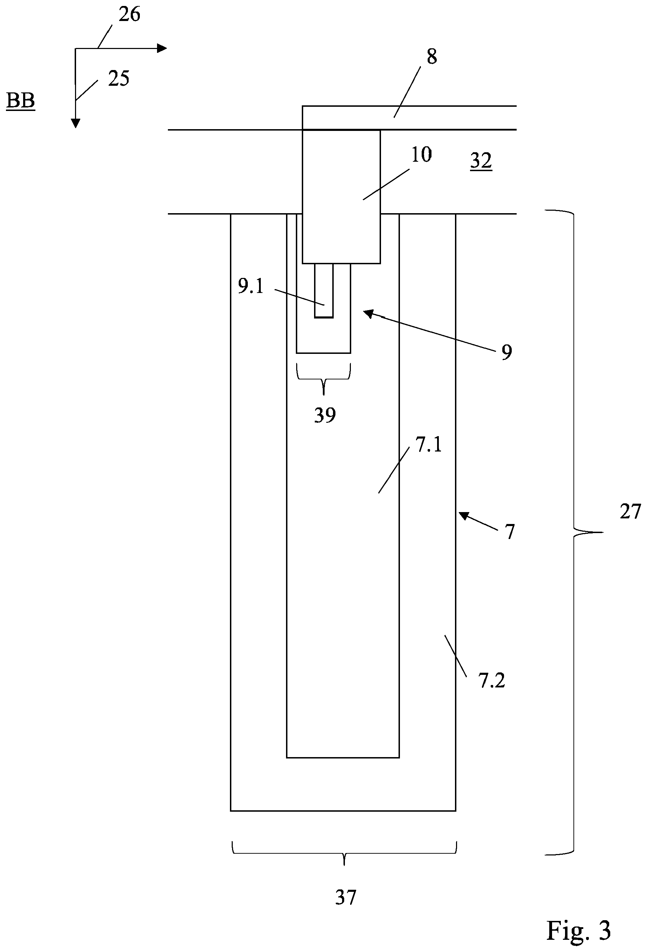

Figure 3 illustrates the shield electrode region 7 in a vertical cross-section, see the sectional plane BB indicated in figure 1. The shield electrode region 7 with the needle-shaped shield electrode 7.1 and a shield dielectric 7.2 is formed in a needle-shaped shield electrode trench 37 etched into the semiconductor body 27. The shield electrode trench 37 extends to the same depth as the field electrode trench 24, namely significantly deeper than the gate trench 23. The connecting gate trench 39 with the connecting gate region 9 and the connecting gate electrode 9.1 extends into the shield electrode region 7, namely intersects the shield dielectric 7.2 (from the front of the drawing plane of figure 3).

To ensure a good electrical contact between the connecting gate electrode 9.1 and the shield electrode 7.1, a vertical interconnect 10 laterally aligned with the shield electrode 7.1 extends down into the shield electrode region 7. Above, the vertical interconnect 10, which can for example be made of tungsten, intersects the insulating layer 32 and connects to the first metallization structure 8. As apparent in conjunction with figure 1, the connecting gate electrode 9.1 connects the shield electrode 7.1 to the gate electrode 3.1 in the active area 14, wherein other shield electrodes arranged towards the lateral edge 6 (towards the right in figure 1) are connected via the vertical interconnect 10 and the first metallization structure 8.

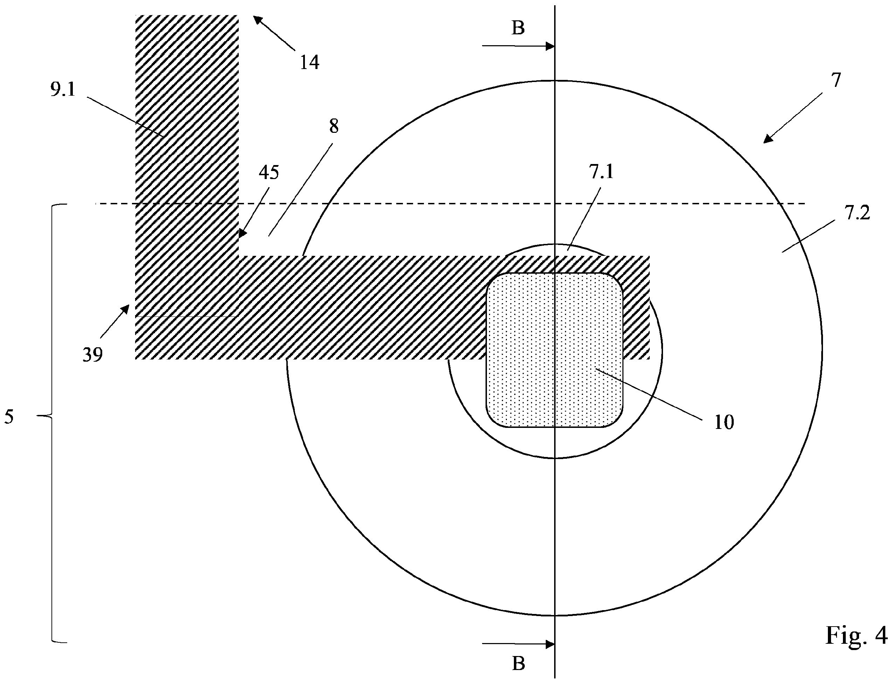

Figure 4 shows the shield electrode region 7 of figure 3 in a top view (rotated by 90° in comparison to figure 1, see the orientation of the sectional plane BB). The connecting gate electrode 9.1 extends in the connecting gate trench 39 from the active area 14 to the edge termination structure 5 and reaches below the first metallization structure 8. There, a bend 45 is formed, and the connecting gate electrode 9.1 extends through the shield dielectric 7.2 into the shield electrode 7.1. The vertical interconnect 10 contacts both of them and forms the contact to the first metallization structure 8.

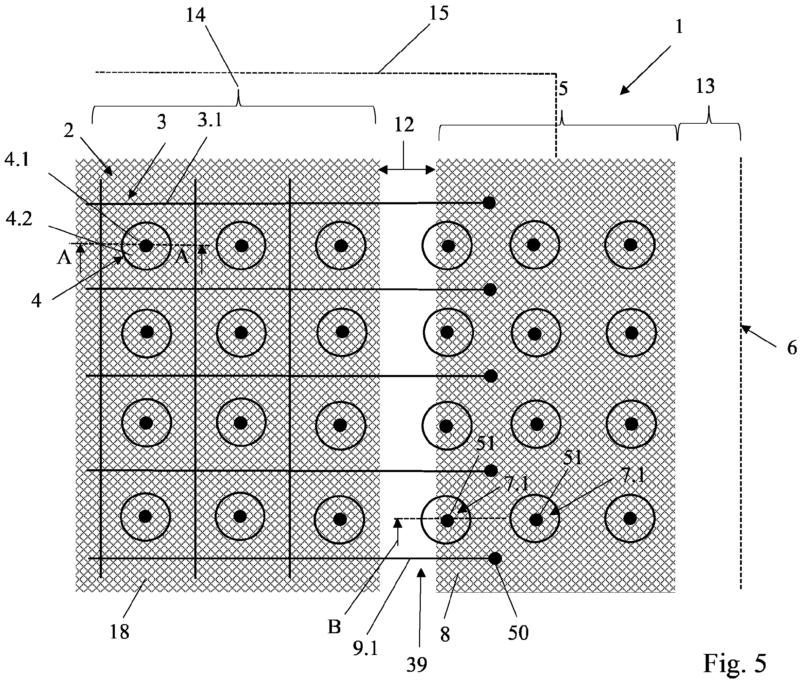

Figure 5 shows an alternative embodiment to figure 1, wherein the same parts or parts with the same function are indicated with the same reference numerals. The device 2 and the shield electrodes 7.1 are constructed as described above, the embodiments differ only in the connection of the connecting gate electrode 9.1 to the shield electrodes 7.1. In this case, the connecting gate trench 39 does not extend into a shield electrode region 7, instead it ends more or less centrally between the shield electrode regions 7. There, the connecting gate electrode 9.1 is connected to the first metallization structure 8 via a vertical interconnect 50, pulling the first metallization structure 8 to gate potential. Further, a respective vertical interconnect 51 connects each of the shield electrodes 7.1 to the first metallization structure 8 and, consequently, to the gate potential.

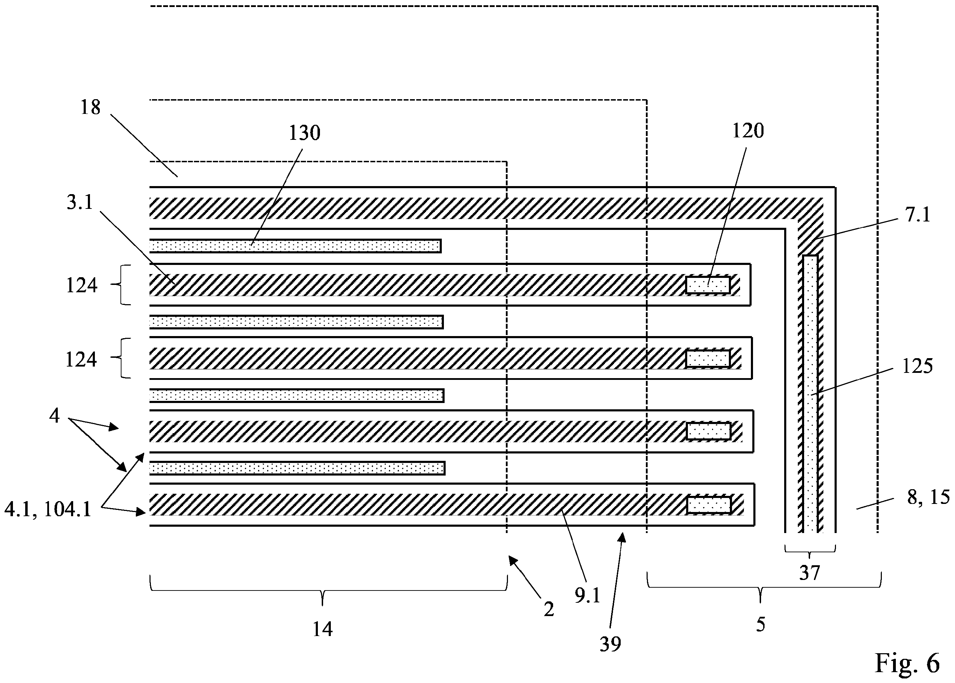

Figure 6 illustrates yet another embodiment. The device 2 comprises field electrode regions 4 formed in field electrode trenches 124, the field electrodes 4.1 formed as field plates 104.1 with an elongated shape and arranged in field electrode trenches 124 (which have also an elongated shape). The gate electrodes 3.1 have an elongated shape as well, each gate electrode 3.1 is arranged above a respective field plate 104.1 in a respective field electrode trench 124. In the top view of Figure 6, the field plates 104.1 are covered by the gate electrodes 3.1. The source and body region of the device 1 are stacked vertically as shown in figure 2, laterally they extend between two respectively neighboring field electrode trenches 124. In figure 6, elongated source (and body) contacts 130 are shown, which respectively intersect an insulating layer on the frontside of the semiconductor body and connect the source and body region to a first metallization plate 18.

In the edge termination structure 5, the shield electrode 7.1 is arranged in the shield electrode trench 37, both having an elongated shape. The elongated extension of the shield electrode 7.1 and shield electrode trench 37 lies perpendicular to the stripes formed by the field and gate electrodes 4.1, 3.1 in the active area 14. The gate electrodes 3.1 are connected via the connecting gate electrodes 9.1 and interconnects 120 to the first metallization structure 8, which forms a gate runner 15. Via an interconnect 125, the shield electrode 7.1, above which no gate electrode is formed, is connected to the first metallization structure 8 and, consequently, to the gate potential.

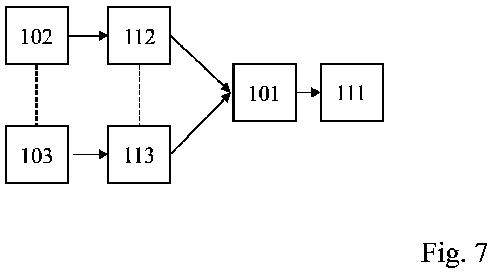

Figure 7 summarizes some process steps 150 for manufacturing the die 1 in a flow diagram. This comprises etching 102 the field electrode trench in the active area 14 of the die 1, wherein the shield electrode trench or trenches are etched 103 simultaneously. Further, the field electrode region and the shield electrode region are formed 112, 113 simultaneously. In the example shown, the etching 101 of the gate trench and forming 111 of the gate region is done subsequently. Alternatively, it could be done prior to the simultaneous steps mentioned.

## Claims

1. A semiconductor die (1) with
a semiconductor device (2) comprising
a gate region (3) with a gate electrode (3.1) in a gate trench (23) for controlling a current flow through the device (2), and
a field electrode region (4) with a field electrode (4.1) in a field electrode trench (24) which is needle-shaped,
an edge termination structure (5) between the semiconductor device (2) and a lateral edge (6) of the die (1), comprising
a shield electrode region (7) with a shield electrode (7.1) in a shield electrode trench (37),
the shield electrode (7.1) electrically connected to the gate electrode (3.1).

2. The semiconductor die (1) of claim 1, wherein a shield dielectric (7.2) of the shield electrode region (7) is thicker than a gate dielectric (3.2) of the gate region (3).

3. The semiconductor die (1) of claim 1 or 2, the shield electrode trench (37) extending deeper than the gate trench (23).

4. The semiconductor die (1) of any one of the preceding claims, wherein the shield electrode trench (37) is needle-shaped, the edge termination structure (5) comprising a plurality of shield electrode regions (7) which are needle-shaped.

5. The semiconductor die (1) of any one of claims 1-3, wherein the shield electrode trench (37) has a longitudinal extension.

6. The semiconductor die (1) of any one of the preceding claims, wherein a connecting gate trench (39) with a connecting gate electrode (9.1) extends from the gate trench (23) of the device (2) to the edge termination structure (5) and connects the gate electrode (3.1) to the shield electrode (7.1)

7. The semiconductor die (1) of claim 6, wherein the connecting gate trench (39) extends laterally into the shield electrode region (7), the gate electrode (3.1) connected to the shield electrode (7.1) via a vertical interconnect (10), which is laterally aligned with the shield electrode (7.1) and contacts the connecting gate electrode (9.1) and the shield electrode (7.1).

8. The semiconductor die (1) of any one of the preceding claims, wherein a first metallization structure (8) is formed vertically above the shield electrode region (7), covering the latter at least partly and electrically connecting the shield electrode (7.1) to the gate electrode (3.1).

9. The semiconductor die (1) of claims 6 and 8, wherein the connecting gate trench (39) extends from the gate trench (23) to below the first metallization structure (8), the connecting gate electrode (9.1) connected to the first metallization structure (8) via a vertical interconnect (50) arranged laterally aside the shield electrode region (7), the shield electrode (7.1) connected to the first metallization structure (8) via an additional vertical interconnect (51).

10. The semiconductor die (1) of claim 8 or 9, wherein the first metallization structure (8) is a gate runner (15) extending along at least one side of the semiconductor die (1).

11. The semiconductor die (1) of any one of claims 8-10, wherein the first metallization structure (8) is formed in a first metallization layer (80), a first metallization plate (18) being additionally formed above the semiconductor device (2) in the first metallization layer (80).

12. The semiconductor die (1) of claim 11, wherein a lateral distance (12) between the first metallization structure (8) and the first metallization plate (18) is 20 µm at maximum.

13. A method of manufacturing the semiconductor die (1) of any one of the preceding claims, comprising the steps
i) etching (101) the gate trench (23) and forming (111) the gate region (3);
ii) etching (102) the field electrode trench (24) and forming (112) the field electrode region (4);
iii) etching (103) the shield electrode trench (37) and forming (113) the shield electrode region (7).

14. The method of claim 13, wherein the field electrode trench (24) and the shield electrode trench (37) are etched simultaneously.

15. The method of claim 13 or 14 for manufacturing the semiconductor die (1) of claim 6, wherein the gate trench (23) and the connecting gate trench (39) are etched simultaneously, the gate electrode (3.1) and the connecting gate electrode (9.1) being in particular formed simultaneously.
